## Europäisches Patentamt
## European Patent Office
## Office européen des brevets

(11) Publication number: **0 029 716**
**B1**

(12)
# EUROPEAN PATENT SPECIFICATION

(45) Date of publication of patent specification: **31.07.85**

(51) Int. Cl.⁴: **G 11 C 17/00**

(21) Application number: **80304171.4**

(22) Date of filing: **20.11.80**

(54) Semiconductor prom device.

(30) Priority: **26.11.79 JP 152832/79**

(43) Date of publication of application:
**03.06.81 Bulletin 81/22**

(45) Publication of the grant of the patent:
**31.07.85 Bulletin 85/31**

(84) Designated Contracting States:
**DE FR GB NL**

(56) References cited:
**US-A-3 649 848**
**US-A-3 683 335**
**US-A-3 863 230**
**US-A-4 130 890**
**US-A-4 159 540**

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13, Yutenji 2-chome**
**Meguro-ku Tokyo 153 (JP)**

(74) Representative: **Allman, Peter John et al**
**Marks and Clerk Scottish Life House Bridge Street**
**Manchester M3 3DP (GB)**

## Description

Background of the invention

(1) Field of the invention

The present invention relates to a semiconductor PROM (Programmable Read Only Memory) device, more particularly to a semiconductor PROM device which uses a high potential voltage when the write-in of information to the semiconductor PROM device is effected, and which is used, for example, in an electronic computer.

(2) Description of the prior art

In a PROM device such as an EPROM (Erasable and Programmable Read Only Memory) device, the write-in of information to each of the memory cells is effected due to the supply of a high potential voltage to each of the memory cells.

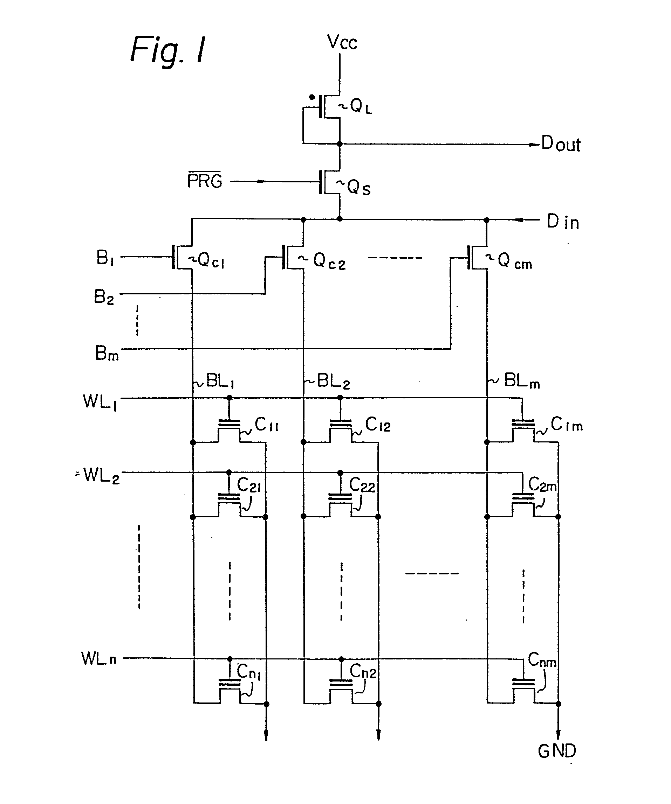

As illustrated in Fig. 1, the EPROM device comprises a plurality of memory cells $C_{ij}$ (i=1, 2, ..., n; j=1, 2, ..., m) disposed in a matrix of n rows and m columns. Each of the memory cells $C_{ij}$ is composed, for example, of a well known floating gate type field effect transistor and is connected between one of word lines $WL_1$, $WL_2$, ..., $WL_n$ and one of bit lines (or column lines) $BL_1$, $BL_2$, ..., $BL_m$. Each of the bit lines $BL_1$, $BL_2$, ..., $BL_m$ is connected through one of gate transistors $Q_{C1}$, $Q_{C2}$, ..., $Q_{Cm}$ respectively to a data input line $D_{In}$. The data input line $D_{In}$ is connected through a switching transistor $Q_S$ to a data output line $D_{out}$ which is connected to a voltage source $V_{CC}$ of, for example, 5 V through a load transistor $Q_L$.

In the EPROM device of Fig. 1, the write-in of information, i.e., programming to the memory cell, for example, $C_{12}$ is effected by supplying a very high potential voltage, for example 20 V, to the selected word line $WL_1$ and supplying a very high potential voltage, for example 20 V, to the data input line $D_{In}$. Also, a bit address signal $B_2$ is caused to be high and the inverted program signal $\overline{PRG}$ is caused to be low, so that the gate transistor $Q_{C2}$ is turned on and the switching transistor $Q_S$ is turned off. Therefore, the programming is achieved by simultaneously applying very high voltages to the drain and the control gate of the selected memory cell $C_{12}$. Hot electrons are generated in the channel of the memory cell $C_{12}$ and injected into the floating gate, resulting in an upward shift in threshold voltage $V_T$ of the memory cell transistor $C_{12}$.

The read-out of information from the selected memory cell, for example, $C_{12}$ is effected by supplying high potential voltage, for example 5 V, to the selected word line $WL_1$. Also, the bit address signal $B_2$ is set to high potential and the inverted program signal $\overline{PRG}$ is set to high, so that the gate transistor $Q_{C2}$ is turned on and the switching transistor $Q_S$ is turned on. If the floating gate of the memory cell $C_{12}$ is charged, no current flows through the main current path of the memory cell transistor $C_{12}$ so that the potential level of the data output line $D_{out}$ becomes high. If the floating gate of the memory cell $C_{12}$ is not

charged, a current flows from the positive voltage source $V_{CC}$ through the transistors $Q_L$, $Q_S$, $Q_{C2}$ and through the memory cell transistor $C_{12}$ to the ground. Therefore, the potential level of the data output line $D_{out}$ becomes low.

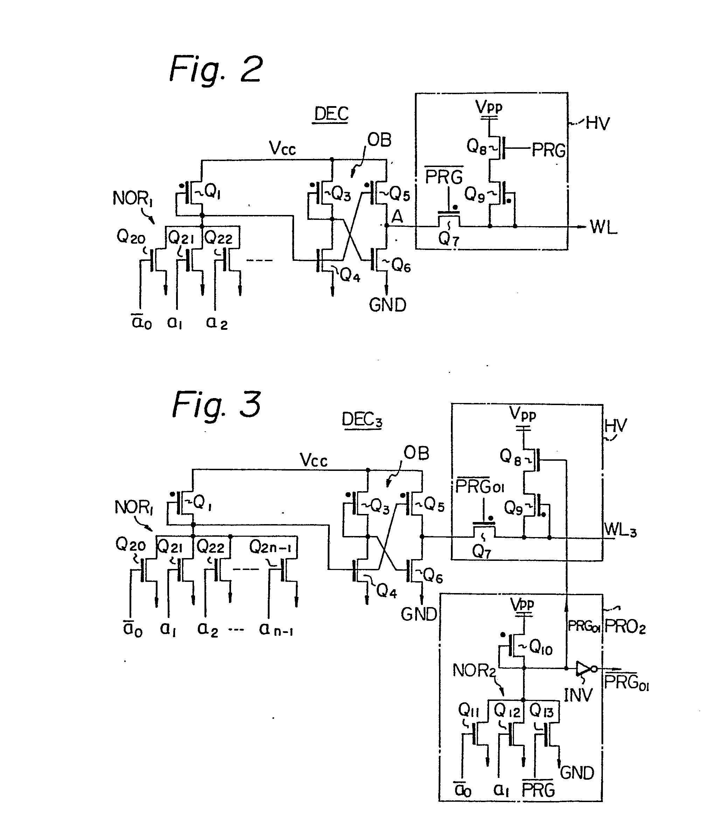

Fig. 2 illustrates a conventional word address decoder DEC having a decoder section and a high potential voltage supplying section HV connected between an output terminal A of the decoder section and the word line WL. The decoder section of the decoder DEC comprises a NOR gate $NOR_1$ consisting of enhancement type transistors $Q_{20}$, $Q_{21}$, $Q_{22}$, ..., and a depletion type load transistor $Q_1$. The decoder section of the decoder DEC further comprises an output buffer circuit OB consisting of a depletion type load transistor $Q_3$, a depletion type transistor $Q_5$ and enhancement type transistors $Q_4$, $Q_6$. The high potential voltage supplying section HV comprises a depletion type transistor $Q_7$ whose main current path is connected between the output terminal A of the decoder section of the decoder DEC and the word line WL, and, a first transistor $Q_8$ of an enhancement type and a second transistors $Q_9$ of a depletion type which are connected in series between the word line WL and a high potential voltage $V_{PP}$ of, for example, 25 V.

The circuit of Fig. 2 operates as follows. When the word line WL is selected, the potential levels of address signals $\overline{a_0}$, $a_1$, $a_2$, ..., are all low and the transistors $Q_{20}$, $Q_{21}$, $Q_{22}$, ..., are all turned off so that the NOR gate $NOR_1$ outputs a signal of high potential level. Therefore, the transistors $Q_4$ and $Q_5$ of the output buffer circuit OB are turned on and the transistor $Q_6$ is turned off, so that the potential level of the output point A of the output buffer circuit OB becomes high.

When the write-in of information if effected, a program signal PRG supplied to the gate electrode of the enhancement type transistor $Q_8$ in the high potential voltage supplying section HV is set to be high potential. Therefore, the transistor $Q_8$ is turned on and a current is supplied from the high potential voltage source $V_{PP}$ whose potential voltage is, for example, 25 V through the transistor $Q_8$ and the depletion type transistor $Q_9$ to the word line WL. In this condition, the potential level of an inverted signal $\overline{PRG}$ of the program signal is low, i.e., OV and the potential level of the output point A is high. Consequently, the transistor $Q_7$, whose main current path is connected between the output point A and the selected word line WL, is turned off, because the gate threshold potential $V_{th}$ of the transistor $Q_7$ is larger than $-V_{CC}$ and is smaller than 0 (i.e., $0 > V_{th} > -V_{CC}$, for example, $V_{th} = -V_{CC}/2$). Therefore, the potential level of the selected word line WL is nearly equal to $V_{PP}$, i.e. 25 V, in the write-in mode.

When the read-out of information is effected, the program signal PRG is caused to be low and the inverted signal $\overline{PRG}$ is caused to be high. Consequently, the transistor $Q_8$ is turned off, the transistor $Q_7$ is turned on, and a current flows from the voltage source $V_{CC}$ through the

depletion type transistor $Q_5$ of the output buffer circuit OB and the transistor $Q_7$ to the selected word line WL. Therefore, the potential level of the selected word line WL is nearly equal to $V_{cc}$, i.e. 5 V, in the read-out mode.

In the non-selected condition of the word line WL of Fig. 2, the potential level of at least one of the address signals $\overline{a_0}$, $a_1$, $a_2$, . . ., is high and at least one of the transistors $Q_{20}$, $Q_{21}$, $Q_{22}$, . . ., is turned on. Therefore, the NOR gate $NOR_1$ outputs a signal of low potential level, the transistors $Q_4$ is turned off and the transistor $Q_6$ is turned on, so that the potential of the output point A becomes low. In this condition, when the program signal PRG is high in the write-in mode, the transistor $Q_8$ is turned on, and, the transistor $Q_7$ is also turned on. This is because, the gate signal $\overline{PRG}$ of the transistor $Q_7$ is low, the potential level of the output point A is low and the gate threshold potential $V_{th}$ of the transistor $Q_7$ is larger than $-V_{cc}$ and is smaller than 0 as mentioned before. Therefore, an idle current flows from the high potential voltage source $V_{PP}$ through the transistors $Q_8$, $Q_9$, $Q_7$ and $Q_6$ to the ground, and the potential of the word line WL becomes low. The transistor $Q_9$ operates to pull up the word line WL to a high potential level when the write-in of information is effected. When the potential level of the word line WL becomes very high, the gate threshold potential $V_{th}$ rises due to the well known back gate bias effect. Therefore, the gate threshold potential $V_{th}$ of the transistor $Q_9$ is set to a low negative value, for example $-5$ V, in order to keep the transistor $Q_9$ in a turned on condition and pull up the word line WL to a very high potential level. Consequently, the above-mentioned idle current becomes large and the power consumption of the memory device increases.

The semiconductor memory device, for example the EPROM device, uses a large number of word address decoders and high potential voltage supplying section, that is, the memory device uses the same number of word address decoders and high potential voltage supplying sections as those of the word lines. Moreover, only one of the word lines can be selected at the same time and all the other word lines are in non-selected condition. Therefore, the above-mentioned idle current becomes very large.

In order to stop or decrease the idle current, there are two methods, i.e. (1) to increase the channel length of the transistor $Q_8$ and (2) to increase the channel length of the transistor $Q_9$. However, in both cases, the integration degree of the semiconductor memory device is decreased. Therefore, in the conventional memory device, the gate threshold potential $V_{th}$ of the transistor $Q_9$ is set to be a low negative value, but, the channel length of the transistors $Q_8$ and $Q_9$ is not increased.

Consequently, in the conventional semiconductor memory device, the idle current flowing in the non-selected decoders in the write-in or programming mode increases and the power consumption of the semiconductor memory device increases according to the increase of the number of the word address decoders.

U.S. Patent No. 3863230 discloses a memory decoder circuit in which each decoder has a structure tailored to match the address signals which are to select it. The described circuit includes a plurality of series connected transistors in a first group and a plurality of parallel connected transistors in a second group, the number of transistors within the two groups being related to the selecting address signals. A further transistor is also provided to prevent idle currents. This arrangement does solve the problem of idle current, but only by requiring different structures for the different address decoders. This requires a complex circuit layout occupying a relatively large area.

It is an object of the present invention to reduce the power consumption of a semiconductor memory device made up from a series of identical decoder structures by decreasing the idle current flowing from the high potential voltage supplying section to the non-selected word address decoders when the write-in of information to the semiconductor PROM device is effected.

According to the present invention, there is provided a semiconductor PROM device comprising a plurality of word address decoders which are substantially identical in structure to each other, each of said word address decoders having a decoder section selecting one word line according to input address signals and a high potential voltage supplying section including a first transistor which is connected between one of said word lines and a high potential voltage source which is used for programming said semiconductor PROM device and which is turned on when programming is effected, and a second transistor which is connected between an output terminal of said decoder section and one of said word lines, characterised in that said semiconductor PROM device comprises a plurality of gated program signal generators which are substantially identical in structure to each other, each of the gated program signal generators being supplied with a part of said input address signals and generating a gated program signal for selecting a block of said word address decoders, said block consisting of one or more of said word address decoders corresponding to said part of said input address signals, and said gated program signal being applied to the gate electrode of said first transistor of said word address decoder whose input address signals include said part of the input address signals supplied to said gated program signal generator.

An embodiment of the invention is described with reference to the accompanying drawings, in which:

Fig. 1 is a partial circuit diagram illustrating a conventional EPROM device;

Fig. 2 is a circuit diagram illustrating a conventional word address decoder;

Fig. 3 is a circuit diagram illustrating a word address decoder and a gated program signal generator embodying the present invention; and

Fig. 4 is a block circuit diagram illustrating connections between a plurality of circuits of the type shown in Fig. 3.

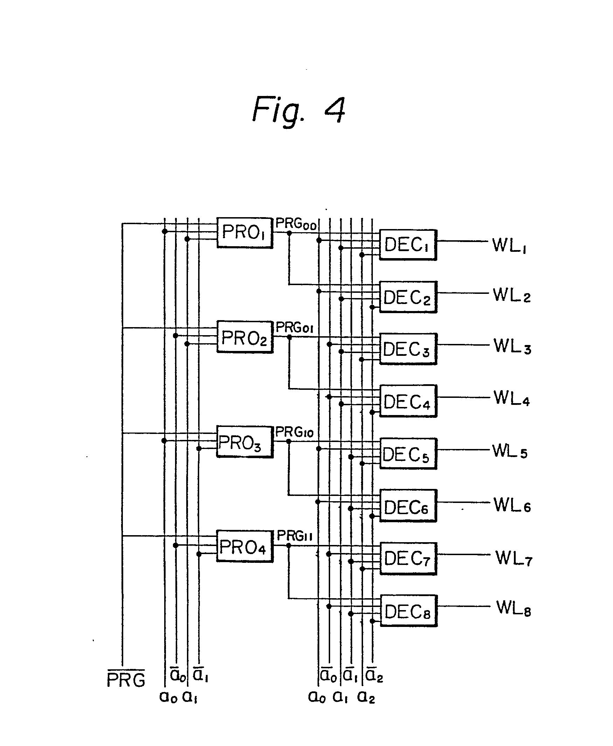

With reference to the accompanying Figs. 3 and 4, a semiconductor PROM device according to the present invention will now be explained. The same parts appearing in Figs. 3 and 4 as appear in Fig. 2 are designated by the same reference symbols and an explanation therefor is omitted herein. In Fig. 3, a word address decoder $DEC_3$, containing a decoder section and a high potential voltage supplying section HV, is connected to a word line $WL_3$ which is selected by address signals $\overline{a_0}, a_1, a_2, \ldots, a_{n-1}$. The structure of the word address decoder $DEC_3$ is the same as that of the word address decoder DEC of Fig. 2, except that the gate electrode of transistors $Q_7$ and $Q_8$ are supplied with gated program signals $PRG_{01}$ and $\overline{PRG_{01}}$, instead of the program signals PRG and $\overline{PRG}$, from a gated program signal generator $PRO_2$ which is newly provided according to the present invention. The gated program signal generator $PRO_2$ comprises a NOR gate $NOR_2$ consisting of gate transistors $Q_{11}, Q_{12}, Q_{13}$ and a load transistor $Q_{10}$, and, an inverter INV. The gated program signal generator $PRO_2$ outputs the gated program signal $PRG_{01}$ of high potential level, i.e., $V_{PP}$ and the gated program signal $\overline{PRG_{01}}$ of low potential level, i.e., OV which is an inverted signal of $PRG_{01}$. The inversion of the gated program signal $PRG_{01}$ is effected by the inverter INV. These signals $PRG_{01}$ and $\overline{PRG_{01}}$ are applied to the gate electrodes of the transistors $Q_8$ and $Q_7$, respectively. Input terminals of the NOR gate $NOR_2$, i.e., the gate electrodes of the transistors $Q_{11}, Q_{12}$ and $Q_{13}$ are supplied with the address signals $\overline{a_0}, a_1$ and the inverted program signal $\overline{PRG}$. When the read-out of information is effected, the inverted program signal $\overline{PRG}$ becomes high, thereby making the gated program signal $PRG_{01}$ low and the inverted signal $\overline{PRG_{01}}$ high, blocking a write-in circuit which is not shown in the drawing, and enabling a read-out circuit such as a sense amplifier which also is not shown in the drawing. The two bit address signals $\overline{a_0}$ and $a_1$ applied to the input terminals of the NOR gate $NOR_2$ are selected from the n bits address signals $a_0, a_1, \ldots, a_{n-1}$. The two bit address signals $\overline{a_0}$ and $a_1$ divide the $2^n$ word lines, which can be designated by the n bits address signals $a_0, a_1, \ldots, a_{n-1}$, into four groups. If the m bit address signals selected from the n bit address signals $a_0, a_1, \ldots, a_{n-1}$ are applied to the NOR gate $NOR_2$, the $2^n$ word lines are divided into $2^m$ groups. The address signals applied to the program signal generator are selected from the address signals applied to the word address decoder which is supplied with a gated program signal from the program signal generator. In the embodiment of Fig. 2, the lower two bits $\overline{a_0}$ and $a_1$

of the address signals $a_0, a_1, \ldots, a_{n-1}$ applied to the decoder $DEC_3$ are applied to the program signal generator $PRO_2$.

Fig. 4 illustrates a total connection between the gated program signal generators and the word address decoders in the condition of n=3 and m=2. In Fig. 4, each of the word address decoders $DEC_1$ through $DEC_8$ has the same circuit structure as that of the decoder $DEC_3$ of Fig. 3 and is provided with three bit address signals. The word address decoder $DEC_1$ is supplied with the address signals $a_0, a_1, a_2$; the word address decoder $DEC_2$ is supplied with the address signals $a_0, a_1, \overline{a_2} \ldots$; and the word address decoder $DEC_8$ is supplied with the address signals $\overline{a_0}, \overline{a_1}, \overline{a_2}$. Each of the word address decoders $DEC_1$ through $DEC_8$ selects correspondingly one of the word lines $WL_1$ through $WL_8$ respectively. Each of the gated program signal generators $PRO_1$ through $PRO_4$ has the same circuit structure as that of the gated program signal generator $PRO_2$ of Fig. 3. The gated program signal generators $PRO_1, PRO_2, PRO_3$ and $PRO_4$ are respectively supplied with sets of two bit address signals $a_0, a_1; \overline{a_0}, a_1; a_0, \overline{a_1}$ and $\overline{a_0}, \overline{a_1}$. Output signals $PRG_{00}$ through $PRG_{11}$ from the gated program signal generators $PRO_1$ through $PRO_4$ are respectively applied to pairs of word address decoders $(DEC_1, DEC_2), (DEC_3, DEC_4), (DEC_5, DEC_6)$ and $(DEC_7, DEC_8)$ which are supplied with the address signals containing the sets of two bit address signals $a_0, a_1; \overline{a_0}, a_1; a_0, \overline{a_1}; \overline{a_0}, \overline{a_1}$ respectively. Inverted output signals $\overline{PRG_{00}}$ through $\overline{PRG_{11}}$ from the gated program signal generators $PRO_1$ through $PRO_4$ are also supplied respectively to the pairs of the word address decoders $(DEC_1, DEC_2), (DEC_3, DEC_4), (DEC_5, DEC_6)$ and $(DEC_7, DEC_8)$. However, illustration of these signals is omitted in Fig. 4 for the sake of simplicity.

In the above-mentioned structure, when the write-in of information, i.e., the programming is effected, the inverted signal $\overline{PRG}$ is low. In this condition, assume that the address signals $\overline{a_0}$ and $a_1$ are both low, in which status the output signal $PRG_{01}$ from the gated program signal generator $PRO_2$ becomes high and the transistors $Q_8$ in the decoders $DEC_3$ and $DEC_4$ are turned on. However, the output signals $PRG_{00}, PRG_{10}$ and $PRG_{11}$ from the gated program signal generators $PRO_1, PRO_3$ and $PRO_4$ are all low and the transistors $Q_8$ in the other decoders $DEC_1, DEC_2$ and $DEC_5$ through $DEC_8$ are all turned off. Therefore, the aforementioned idle current does not flow in these other non-selected decoders. Only one of the decoders $DEC_3$ and $DEC_4$ is selected according to the condition of the remaining address signal $a_2$ or $\overline{a_2}$. For example, when the address signal $a_2$ is low, the decoder $DEC_3$ is selected and the other decoder $DEC_4$ is not selected. The aforementioned idle current flows in the non-selected decoder $DEC_4$. However, the idle current flows in the only one decoder $DEC_4$ in this case, and therefore the amount of the idle current decreases to 1/7 of that of the conventional memory device having the word address decoder of Fig. 2.

The idle current can be decreased to zero by applying three bit address signals to each of the eight gated program signal generators in order to select only one of them and by applying the gated program signal from the selected generator to a selected one of the decoders $DEC_1$ through $DEC_8$. However, such a system needs the same number of gated program signal generators as that of the word address decoders and needs a large number of semiconductor elements and connecting leads. Consequently, the integration degree of the memory device which uses such a system is decreased. Therefore, it is preferable to use a smaller number of gated program signal generators than that of the word address decoders.

It should be noted that, in Figs. 3 and 4, any set of two bit address signals can be applied to the gated program signal generators. For example, in Figs. 3 and 4, the sets of address signals consisting of $a_0$ (or $\overline{a_0}$) and $a_2$ (or $\overline{a_2}$) or consisting of $a_1$ (or $\overline{a_1}$) and $a_2$ (or $\overline{a_2}$) can be used.

According to the present invention, in the semiconductor memory device comprising a plurality of word address decoders each of which has the high potential voltage supplying section in the output stage, the word address decoders are divided into a plurality of blocks. Only one of the blocks is selected and the other blocks are not selected at the same time so that the high potential voltage supplying section in the word address decoders in the non-selected blocks are blocked. Therefore, the total power dissipation of the memory device in the programming status can be greatly reduced.

## Claims

1. A semiconductor PROM device comprising a plurality of word address decoders ($DEC_3$) which are substantially identical in structure to each other, each of said word address decoders ($DEC_3$) having a decoder section ($NOR_1$, OB) selecting one word line ($WL_3$) according to input address signals ($\overline{a_0}$, $a_1$, $a_2$—$a_{n-1}$) and a high potential votlage supplying section (HV) including a first transistor ($Q_8$) which is connected between one of said word lines ($WL_3$) and a high potential voltage source ($V_{pp}$) which is used for programming said semiconductor PROM device and which is turned on when programming is effected, and a second transistor ($Q_7$) which is connected between an output terminal (A) of said decoder section ($NOR_1$, OB) and one of said word lines ($WL_3$), characterised in that said semiconductor PROM device comprises a plurality of gated program signal generators ($PRO_2$) which are substantially identical in structure to each other, each of the gated program signal generators being supplied with a part of said input address signals ($\overline{a_0}$, $a_1$) and generating a gated program signal ($PRG_{01}$) for selecting a block of said word address decoders ($DEC_3$), said block consisting of one or more of said word address decoders ($DEC_3$) corresponding to said part of said input addres

signals ($\overline{a_0}$, $a_1$), and said gated program signal ($PRG_{01}$) being applied to the gate electrode of said first transistor ($Q_8$) of said word address decoder ($DEC_3$) whose input address signals ($a_0$, $a_1$, $a_2$, . . ., $a_{n-1}$) include said part of the input address signals ($\overline{a_0}$, $a_1$) supplied to said gated program signal generator ($PRO_2$).

2. A semiconductor PROM device as set forth in claim 1, wherein said semiconductor PROM device includes inverter means (INV) generating inverted signals of said gated program signals ($\overline{PRG_{01}}$), each of said inverted signals ($\overline{PRG_{01}}$) being applied to the gate electrode of said second transistor ($Q_7$) of the corresponding word address decoder ($DEC_3$).

3. A semiconductor PROM device as set forth in claim 1 or 2, wherein said gated program signal generator ($PRO_2$) comprises a decoder circuit ($NOR_2$) whose input terminals are supplied with said part of the input address signals ($\overline{a_0}$, $a_1$) and a program signal ($\overline{PRG}$) which changes its potential level according to the change between write-in status and read-out status.

4. A semiconductor PROM device as set forth in claim 3, wherein said decoder circuit ($NOR_2$) comprises a NOR gate.

5. A semiconductor PROM device as set forth in claim 4, wherein said NOR gate comprises a plurality of inverter transistors ($Q_{11}$, $Q_{12}$, $Q_{13}$) connected in parallel to each other and a load transistor ($Q_{10}$).

## Patentansprüche

1. Halbleiter-PROM-Vorrichtung, mit einer Vielzahl von Wortadreßdecodern ($DEC_3$), welche im wesentlichen jeweils die identische Struktur aufweisen und die jeweils einen Decoderabschnitt ($NOR_1$, OB) haben, der eine Wortleitung ($WL_3$) entsprechend Eingangsadreßsignalen ($\overline{a_0}$, $a_1$, $a_2$—$a_{n1}$) auswählt, und einen Spannungsversorgungsabschnitt (HV) hohen Potentials, welcher wenigstens einen ersten Transistor ($Q_8$) umfaßt, der zwischen einer der genannten Wortleitungen ($WL_3$) und einer Spannungsquelle ($V_{pp}$) hohen Potentials angeschlossen ist, die zur Programmierung der genannten Halbleiter-PROM-Vorrichtung verwendet wird, und der eingeschaltet wird, wenn die Programmierung durchgeführt wird, und einen zweiten Transistor ($Q_7$), der zwischen einem Ausgangsanschluß (A) des genannten Decoderabschnitts ($NOR_1$, OB) und einer der genannten Wortleitungen ($WL_3$) angeschlossen ist, dadurch gekennzeichnet, daß die genannten Halbleiter-PROM-Vorrichtung eine Vielzahl von Stromtor-Programmsignalgeneratoren ($PRO_2$) umfaßt, die im wesentlichen jeweils eine identische Struktur aufweisen, und denen ein Teil der genannten Eingangsadreßsignale ($\overline{a_0}$, $a_1$) zugeführt wird und ein torgesteuertes Programmsignal ($PRG_{01}$) zur Auswahl eines Blocks der genannten Wortadreßdecoder ($DEC_3$) zugeführt wird, wobei der genannte Block aus einer oder mehreren der genannten Wortadreßdecodern ($DEC_3$) besteht,

die dem genannten Teil der genannten Eingangs-adreßsignale $(\overline{a_0}, a_1)$ entsprechen, und daß das genannte torgesteuerte Programmsignal ($PRG_{01}$) der Gateelektrode des genannten ersten Transistors ($Q_8$) der genannten Wortadreßdecoder ($DEC_3$) zugeführt wird, deren Eingangs-adreßsignale ($a_0$, $a_1$, $a_2$, ..., $a_{n-1}$) den genannten Teil der Eingangsadreßsignale $(\overline{a_0}, a_1)$ enthalten, die dem genannten torgesteuerten Programm-signalgenerator ($PRO_2$) zugeführt werden.

2. Halbleiter-PROM-Vorrichtung nach Anspruch 1, bei welcher die genannte Halbleiter-PROM-Vorrichtung Invertereinrichtungen (INV) umfaßt, welche invertierte Signale der genannten torge-steuerten Programmsignale ($\overline{PRG_{01}}$) erzeugen, von denen jedes invertierte Signal ($\overline{PRG_{01}}$) der Gateelektrode des genannten zweiten Transistors ($Q_7$) des entsprechenden Wortadreßdecoders ($DEC_3$) zugeführt wird.

3. Halbleiter-PROM-Vorrichtung nach Anspruch 1 oder 2, bei welcher der torgesteuerte Programmsignalgenerator ($PRO_2$) eine Decoder-schaltung ($NOR_2$) umfaßt, deren Eingangs-anschlüssen der genannte Teil der Eingangs-adreßsignale $(\overline{a_0}, a_1)$ und ein Programmsignal ($\overline{PRG}$) zugeführt wird, welches seinen Potentialpegel entsprechend der Änderung zwischen dem Einschreibstatus und dem Auslesestatus ändert.

4. Halbleiter-PROM-Vorrichtung nach Anspruch 3, bei welcher die genannte Decoderschaltung ($NOR_2$) ein NOR-Glied umfaßt.

5. Halbleiter-PROM-Vorrichtung nach Anspruch 4, bei welcher das genannte NOR-Glied eine Vielzahl von Invertertransistoren ($Q_{11}$, $Q_{12}$, $Q_{13}$) umfaßt, die parallel zueinander und mit einem Lasttransistor ($Q_{10}$) verbunden sind.

## Revendications

1. Mémoire morte programmable PROM à semiconducteurs comprenant un ensemble de décodeurs d'adresse de mot ($DEC_3$) qui sont essentiellement identiques entre eux du point de vue structure, chacun des décodeurs d'adresse de mot ($DEC_3$) comportant une section de décodeur ($NI_1$, OB) sélectionnant une ligne de mots ($WL_3$) conformément aux signaux d'adresse d'entrée $(\overline{a_0}, a_1, a_2—a_{n-1})$ et une section d'alimentation en tension élevée (HV) incluant un premier transistor ($Q_8$) qui est connecté entre une des lignes de mots ($WL_3$) et une source de tension élevée ($V_{PP}$) qui est utilisée pour programmer la mémoire PROM à semiconducteurs et qui est branchée quand une programmation est effectuée, et un second tran-sistor ($Q_7$) qui est connecté entre une borne de sortie (A) de la section de décodeur ($NI_1$, OB) et une des lignes de mots ($WL_3$), caractérisée en ce qu'elle comprend un ensemble de générateurs de signaux de programme transférés condition-nellement ($PRO_2$) qui ont des structures essentiellement identiques entre elles, chacun des générateurs de signaux de programme transférés conditionnellement recevant une partie des signaux d'adresse d'entrée $(\overline{a_0}, a_1)$ et engendrant un signal de programme transféré condition-nellement ($PRG_{01}$) pour sélectionner un bloc des décodeurs d'adresse de mot ($DEC_3$), le bloc étant constitué d'un ou de plusieurs décodeurs d'adresse de mot ($DEC_3$) correspondant à la partie des signaux d'adresse d'entrée $(\overline{a_0}, a_1)$, et le signal de programme transféré conditionnellement ($PRG_{01}$) étant envoyé à l'électrode de grille du premier transistor ($Q_8$) du décodeur d'adresse de mot ($DEC_3$) dont les signaux d'adresse d'entrée ($a_0$, $a_1$, $a_2$, ..., $a_{n-1}$) comprennent la partie des signaux d'adresse d'entrée $(\overline{a_0}, a_1)$ envoyée au générateur de signal de programme transféré conditionnellement ($PRO_2$).

2. Mémoire PROM à semiconducteurs selon la revendication 1, caractérisée en ce qu'elle comprend un moyen inverseur (INV) engendrant des signaux inversés desdits signaux de pro-gramme transférés conditionnellement ($\overline{PRG_{01}}$), chacun des signaux inversés ($\overline{PRG_{01}}$) étant envoyé à l'électrode de grille du second transistor ($Q_7$) du décodeur d'adresse de mot correspondant ($DEC_3$).

3. Mémoire PROM à semiconducteurs selon l'une quelconque des revendications 1 et 2, caractérisée en ce que le générateur de signal de programme transféré conditionnellement ($PRO_2$) comprend un circuit décodeur ($NI_2$) dont les bornes d'entrée reçoivent ladite partie des signaux d'adresse d'entrée $(\overline{a_0}, a_1)$ et un signal de programme ($\overline{PRG}$) dont le niveau de tension varie conformément au changement entre un état d'écriture et un état de lecture.

4. Mémoire PROM à semiconducteurs selon la revendication 3, caractérisée en ce que le circuit décodeur ($NI_2$) comprend une porte NI.

5. Mémoire PROM à semiconducteurs selon la revendication 4, caractérisée en ce que ladite porte NI est constituée d'un ensemble de tran-sistors inverseurs ($Q_{11}$, $Q_{12}$, $Q_{13}$) connectés en parallèle entre eux et d'un transistor de charge ($Q_{10}$).

**Fig. 1**

0 029 716

## Fig. 2

## Fig. 3

# Fig. 4